# EUROPEAN PATENT APPLICATION

(11) **EP 2 693 502 A1**
(43) Date of publication of application: **05.02.2014**
(21) Application number: 12763827.8
(22) Date of filing: 27.03.2012
(51) Int. Cl.: H01L 35/28

(54) **THERMOELECTRIC CLUSTER, METHOD FOR OPERATING SAME, DEVICE FOR CONNECTING AN ACTIVE ELEMENT IN SAID CLUSTER TO A THERMOELECTRIC DRIVE, GENERATOR (VARIANTS) AND HEAT PUMP (VARIANTS) BASED THEREON**

(30) Priority: 29.03.2011 RU 2011111622
(71) Applicant: Vernikovsky, Yury Felixovich, Moscow 123098 (RU); Streletsky, Sergei Nikolaevich, Moscow 119331 (RU)
(72) Inventor: Vernikovsky, Yury Felixovich, Moscow 123098 (RU); Streletsky, Sergei Nikolaevich, Moscow 119331 (RU)
(74) Representative: HOFFMANN EITLE
(86) International application number: PCT/RU2012/000218
(87) International publication number: WO 2012/134348

(57) **Abstract**

The inventions are directed to the production of electrical power and/or heat transfer in heating and cooling devices. All embodiments of a generator and a heat pump are based on a method for operating a thermoelectric cluster, in which the respective heat-transfer agent is caused to directly act on the respective thermoelectric conductors. All of the apparatuses use a device for connecting an active element 1 to thermoelectric conductors 4 and 5, the device comprising an electrically and heat conductive non-solidifying plastic mixture, or a solder having a melting point below operating temperature, or a foil of a ductile metal alloy, wherein the thermoelectric conductor and the active element are resiliently urged against each other. The resulting thermoelectric cluster comprises active elements 1 having the size in the direction of electrical current no less than three times smaller than the size in the perpendicular direction thereto.

## Description

The inventions relate to the objects operating on two thermoelectric effects of the same nature - the Seebeck and Peltier effects. Therefore, the purpose of inventions is for the production of electrical power and/or heat transfer in heating and cooling devices.

It is known a method of operating a thermoelectric module in which thermocouples consisting of two dissimilar elements with p- and n-type conductivity are interconnected by commuting copper plates and enclosed between two flat ceramic plates based on aluminum oxide or aluminum nitride, through which heat is delivered to one side and removed from the other (see http://www.kryotherm.ru/ru/index.phtml?tid=23; http://www.advengineering.ru/ pro/ohmodul.html).

In the known devices, a heat flow is interrupted by an insulating layer of considerable thickness (ceramic plates based on aluminum oxide or aluminum nitride with anisotropic thermal conductivity), which thermal conductivity is significantly lower than the one of electricity conductors. Thus, a thermal barrier is created on this insulation layer, which prevents the effective transfer of heat through the thermoelectric semiconductor. Moreover, this insulation is in contact with the adjacent surfaces, which also causes the loss of thermal conductivity at these contacts.

The technical result (effect) of the claimed method of operating a thermoelectric cluster is to increase the efficiency of the cluster by means of the heat transfer through the thermoelectric semiconductor while bypassing any significant thermal barriers. This means that the heat flow encounters only electrically conductive materials, which are good isotropic thermoelectric conductors, on its path to (from) the thermoelectric semiconductor(s).

Said technical effect is achieved by the fact that in the method of operating a thermoelectric cluster, in which some thermoelectric conductors are engaged with a hot heat-transfer agent, and other thermoelectric conductors are engaged with a cold heat-transfer agent, the respective heat-transfer agent is caused to directly act on the thermoelectric conductors.

It is known a device for connecting a branch to a bus-bar in a thermoelectric module by soldering using low active rosin fluxes with minimum ion component concentrations for enhanced corrosion resistance of modules. (see http://sctbnord.com/article.php?id=191&rus=1).

The soldered contact is a rigid mechanical connection which simultaneously provides the positioning of the branches, a electrothermoconductive contact of the bus-bar with the branches, and the structural strength of the module as a whole. Since the modern soldered modules operate at a significant temperature difference between their working surfaces, especially for cyclic applications, thermal stresses arise, especially at the periphery of the module. This reduces the allowable operating temperature difference, accelerates the aging process of the module (damage and cracking of branches) and limits the size of both the branches and the module as a whole.

A device for connecting an active element with a thermoelectric conductor in a thermoelectric cluster is directed to a technical result (effect) lying in improving reliability of the connection by creating a thermoelectric conductive contact using an electrically and heat conducting non-solidifying plastic mixture or a solder having a melting point below operating temperature, or a foil of a ductile metal alloy.

It is known a thermoelectric module comprising the following branches:
- bismuth telluride (Bi₂Te₃) crystals (branches) of p- and n-type. The geometrical dimension of the crystals: cross-section from 0.35 x 0,35mm to 2.4 x 2.4 mm, height 0.3-5 mm (see http://www.crystalltherm.com/downloads/products catalogue ru_2010. pdf);
- bismuth telluride (Bi₂Te₃) crystals (branches) of p- and n-type of conduction with a metalized coating for thermoelectric cooling modules. The geometrical dimension of the crystals (length, width and height): 1.4x1.4x1.6mm (see http://www.adv-engineering.ru /pro/telvism.html);
- bismuth telluride (Bi₂Te₃) crystals (branches) of p- and n-type of conduction for thermoelectric generator modules. The geometrical dimension of the crystals: cross section 5 x 5 mm (see http://www.adv-engineering.ru/pro/telvism.html);
- bismuth telluride (Bi₂Te₃) crystals (branches) of p- and n-type. The geometrical dimension of the crystals: cross-section from 0.8x0.8mm to 2.5x2.5mm (see http://sctbnord.com/article. php?id=191&rus=1).

The small branches that are used in the modern thermoelectric modules are industrially produced by sawing washers obtained from ingots. Due to a rectangular shape of the branches and considerable width of a cut, a significant part of the thermoelectric material ends up in waste.

Based on the analysis of the design technological features of the production of the thermoelectric modules and operating conditions thereof, it is follows the fact that the branches are the "weakest" link in the module design. This fact has been confirmed by studies of the structural properties of thermoelectric materials based on bismuth telluride (Bi₂Te₃), as well as by the results of compression and tension mechanical tests for the branches. The tests showed that the samples have high structural heterogeneity based on differences in thickness and length of the grains. The differences are also observed between various areas of the samples of plates. There is a difference in the crystallographic orientation of grains, which can be noticed in macro volumes, as well as the presence of fragmentation of grains and possibly pores between fragments. This, in turn, explains a significant spread of the mechanical characteristics of semiconductor branches. The above-mentioned structural heterogeneity of the thermoelectric material and the spread of mechanical characteristics of the branches negatively affect the stability and physical and mechanical properties of the branches, and as a result, the reliability of the thermoelectric module.

The claimed thermoelectric cluster is directed to a technical effect lying in increasing its reliability and efficiency by increasing the size of active elements up to the size of washers, so that the step of sawing washers into branches can be omitted.

The said technical effect is achieved by the fact that the thermoelectric cluster comprises active elements having the size in the direction of electric current no less than three times smaller than the size in the perpendicular direction thereto.

The active elements can be joined to thermoelectric conductors by an electrically and heat conductive non-solidifying plastic mix, or a solder with a melting point below the operation temperature, or a foil of a ductile metal alloy, and surrounded by elastic positioning protective elements placed in depressions in the thermoelectric conductors.

The thermoelectric conductors may be formed in the shape of wedges, resiliently urged along the row against the active elements located between them, and fixed from moving in other directions by a holding frame made of an electrically non-conductive material or electrically isolated from the thermoelectric conductors.

It is known a thermoelectric generator comprising at least one thermoelectric module having an infrared radiation (IR) receiving surface and cooled by a liquid on the cold side (see http://www.globalte.com/pdf/teg_8550_manual.pdf).

It is known a thermoelectric generator comprising at least one thermoelectric module having a hot side heated by liquid and a cold side cooled by liquid (see http://www.kryotherm.ru/ ru/index.phtml?tid=45).

It is known a thermoelectric generator comprises a thermoelectric module having thermoelectric conductors with an IR receiving surface and thermoelectric conductors cooled by gas medium (http://www.globalte.com/pdf/teg_8550_manual.pdf).

It is known a heat pump comprises at least one thermoelectric module having heat exchangers, some of the heat exchangers being joined to a circuit of one heat-transfer agent, and the other to a circuit of a second heat-transfer agent (see http://www.kryotherm.ru/ru/index.phtml?tid=82 or http://www. termiona.ru/ru/products/6-termostabilization/43-built-in-thermal-stabilization-system-tss).

It is known a heat pump comprising at least one thermoelectric module having a heat exchanger in contact with a circuit of liquid heat-transfer agent and a heat exchanger in contact with a gaseous medium (see http://www.eicsolutions.com/thermoelectric-air-conditioners.php).

All aforementioned generators and heat pumps have drawbacks that can be explained by the drawbacks of their thermoelectric modules that have a classical design.

The embodiments of generators and heat pumps are directed to the technical effect lying in increasing the reliability thereof, efficiency and technological simplicity.

The technical effect in a generator according to a first embodiment, comprising at least one thermoelectric cluster having thermoelectric conductors with an IR receiving surface and thermoelectric conductors cooled by liquid, is achieved by the fact that said thermoelectric conductors are arranged at least in one row and formed in the shape of wedges, between which active elements are located, said active elements having the size in the direction of electric current smaller than the size in the perpendicular direction thereto, wherein the liquid-cooled wedges are hollow to circulate a cooling electrically non-conductive liquid therein.

The liquid-cooled wedges can be joined to a collector being in the form of separate parts movably connected with one another along the row of wedges.

The technical result in a generator according to a second embodiment, comprising at least one thermoelectric cluster having thermoelectric conductors heated by hot liquid and thermoelectric conductors cooled by cold liquid, is achieved by the fact that the thermoelectric conductors being arranged at least in one row and formed in the shape of hollow wedges to circulate respective electrically non-conductive liquids therein, wherein the active elements located between the wedges have the size in the direction of electric current smaller than size in the perpendicular direction thereto.

Cavities of the hot thermoelectric conductors may be joined to a collector for the electrically non-conductive hot liquid, and cavities of the cold thermoelectric conductors are joined to a collector for the cold electrically non-conductive liquid, wherein the collectors being in the form of separate parts movably connected with one another along the row of wedges.

The thermoelectric generator may be mounted in a case and may further comprise means for heating hot electrically non-conductive liquid, at least one radiator for cooling cold electrically non-conductive liquid, a pump to circulate cold electrically non-conductive liquid, a pump to circulate hot electrically non-conductive liquid, expansion tanks, at least one fan, a plug load, an ammeter, a voltmeter, a heat indicator and an overload indicator.

The technical effect in a generator according to a third embodiment, comprising at least one thermoelectric cluster having thermoelectric conductors heated or cooled by a liquid heat-transfer agent, and thermoelectric conductors respectively cooled or heated by a gaseous medium, is achieved by the fact that the thermoelectric conductors being formed in the shape of wedges, between which active elements are located, the active elements have the size in the direction of the electric current smaller than the size in the perpendicular direction thereto, wherein the wedges contacting with the liquid heat-transfer agent are hollow to circulate an electrically non-conductive liquid therein, and the wedges contacting with the gaseous medium have ribs to cooperate with the gas medium.

The wedges contacting with the liquid heat-transfer agent can be engaged with collector being in the form of separate parts movably connected with each other.

The technical effect in a generator according to a fourth embodiment, comprising a thermoelectric cluster having thermoelectric conductors with an IR receiving surface and thermoelectric conductors cooled by a gaseous medium, is achieved by the fact that the thermoelectric conductors being arranged coaxially with an infrared radiation (IR) source or configured as circumferentially arranged wedges, and active elements located between them, the active elements have the size in the direction of electric current smaller than that in the perpendicular direction thereto, wherein the inner thermoelectric conductors are configured to cooperate with the IR source, and the outer thermoelectric conductors have ribs to cooperate with the gaseous medium.

The thermoelectric generator can be mounted in a case limiting between the generator and the outer thermoelectric conductors an annular channel which communicates in the upper part with a discharge channel for combustion products of the IR source.

The technical effect in a heat pump according to a first embodiment, comprising at least one thermoelectric cluster having thermoelectric conductors, some of the thermoelectric conductors being connected to a circuit of one heat-transfer agent, and the other thermoelectric conductors being connected to a circuit of the other heat-transfer agent, is achieved by the fact that the thermoelectric conductors are arranged at least in one row and formed in the shape of hollow wedges to circulate respective electrically non-conductive liquids therein, wherein the active elements located between the wedges have the size in the direction of electric current smaller than the size in the perpendicular direction thereto.

Cavities of the wedges can be joined to respective collectors, one of which communicates with one circuit and the other communicates with the other circuit, wherein the collectors are in the form of separate parts movably connected with one another along the row of wedges.

The technical result in a heat pump according to a second embodiment, comprising at least one thermoelectric cluster having thermoelectric conductors contacting with a circuit of liquid heat-transfer agent and thermoelectric conductors contacting with a gaseous medium, is achieved by the fact that the thermoelectric conductors being formed in the shape of wedges between which active elements are located, said active elements have the size in the direction of electric current smaller than the size in the perpendicular direction thereto, wherein the wedges contacting with the liquid heat-transfer agent are hollow to circulate electrically non-conductive liquid therein, and the wedges contacting with the gaseous medium have ribs to cooperate with the gas medium.

The wedges contacting with the liquid heat-transfer agent can be engaged with a collector being in the form of separate parts movably connected with one another.

In a generator and a heat pump according to any of the embodiments the active elements can be joined to thermoelectric conductors by an electrically and heat conductive non-solidifying plastic mix, or a solder having a melting point below the operating temperature, or a foil of a ductile metal alloy, and surrounded by elastic positioning protective elements placed in depressions of the thermoelectric conductors.

In a generator and a heat pump according to any of the embodiments the thermoelectric conductors can be resiliently urged along the row against the active elements located between them and fixed from moving in other directions by a holding frame made of an electrically non-conductive material or electrically isolated from the thermoelectric conductors.

The essence of invention will be further described with reference to the drawings.
Fig. 1 shows a longitudinal sectional view of a thermoelectric cluster;
Fig. 2 shows a general view of a thermoelectric cluster;
Fig. 3 shows a coaxial implementation of a cluster;
Fig. 4 shows a thermoelectric cluster with six pairs of active elements;

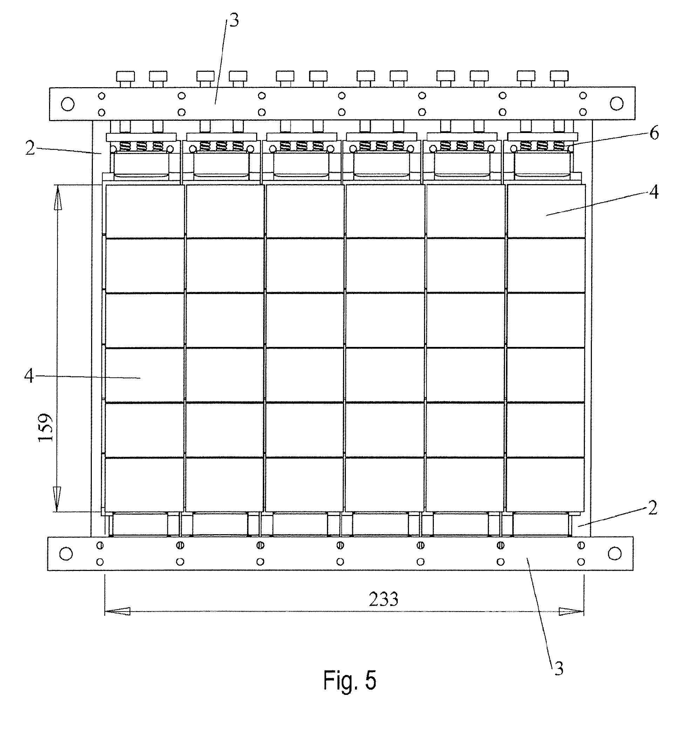

Fig. 5 shows a thermoelectric unit of clusters from the side of infrared heating;
Fig. 6 shows a thermoelectric unit of clusters from the side of a collector;
Fig. 7 shows a holding frame of the unit of clusters;
Fig. 8 shows flows of cooling electrically non-conductive liquid in the unit of clusters;
Fig. 9 shows a generator cluster according to a second embodiment;
Fig. 10 shows a side view of a unit of clusters of the generator according to a second embodiment;
Fig. 11 shows a holding frame of a unit of clusters of generator according to a second embodiment;
Fig. 12 shows flows of heating electrically non-conductive liquid in the unit of clusters;
Fig. 13 shows flows of cooling electrically non-conductive liquid in the unit of clusters;
Fig. 14 shows a generator cluster according to a third embodiment;
Fig. 15 shows a side view of the unit of the clusters of generator according to a third embodiment;
Fig. 16 shows a longitudinal section of the unit of the clusters of generator according to a third embodiment;
Fig. 17 shows a generator cluster according to a fourth embodiment;
Fig. 18 shows a side view of the unit of the clusters of generator according to a fourth embodiment;
Fig. 19 shows a longitudinal section of a generator according to a fourth embodiment;
Fig. 20 shows a heat pump cluster according to a first embodiment;
Fig. 21 shows a side view of a unit of the clusters of heat pump according to a first embodiment;
Fig. 22 shows a holding frame for a unit of the clusters of heat pump according to a first embodiment;
Fig. 23 shows flows of heated electrically non-conductive liquid in a unit of clusters;
Fig. 24 shows flows of cooling electrically non-conductive liquid in a unit of clusters;
Fig. 25 shows a heat pump cluster according to a second embodiment;
Fig. 26 shows a side view of a unit of the clusters of heat pump according to a second embodiment;
Fig. 27 shows a longitudinal section of a unit of the clusters of heat pump according to a second embodiment.

All of the above inventions are based on an integrated assembly hereinafter referred to as "thermoelectric cluster".

In fact, a thermoelectric module widely manufactured in modern industry and the thermoelectric cluster have much in common in terms of functionality and physical principles of operation, on which their work is based.

However, the introduction of the term "thermoelectric cluster" is caused by significant distinctions of the cluster from the thermoelectric module, in particular:
- there is no significant thermal barriers on the path of thermal stream to (from) active element(s) 1;
- active elements 1 have a large size (much larger than in modules);
- cluster as a whole is capable to continue operation when its separate parts are moved due to significant cyclic temperature deformations;
- active elements 1 have reliable protection against the environment.

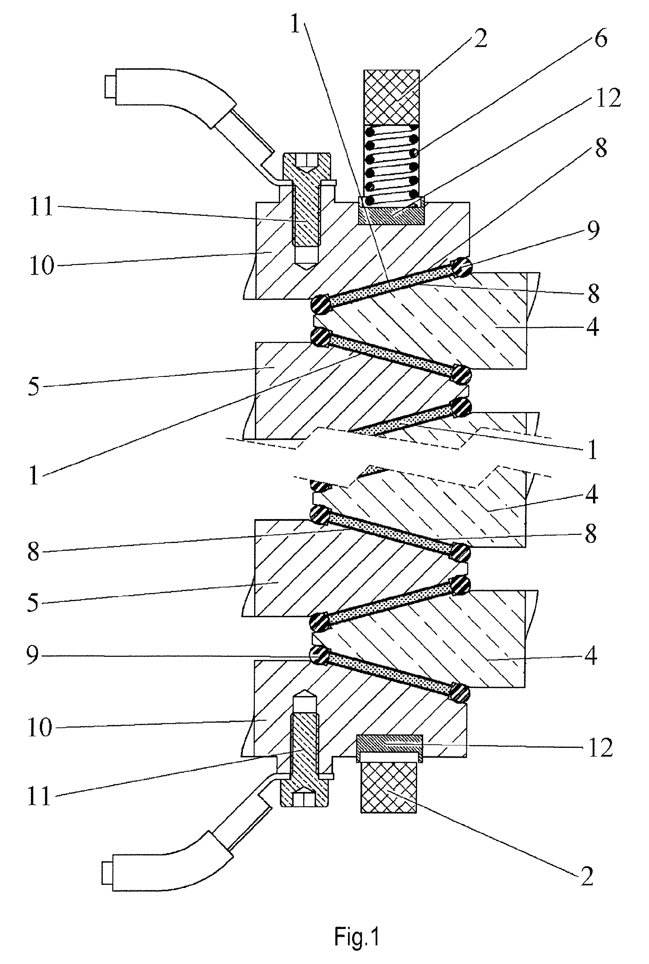

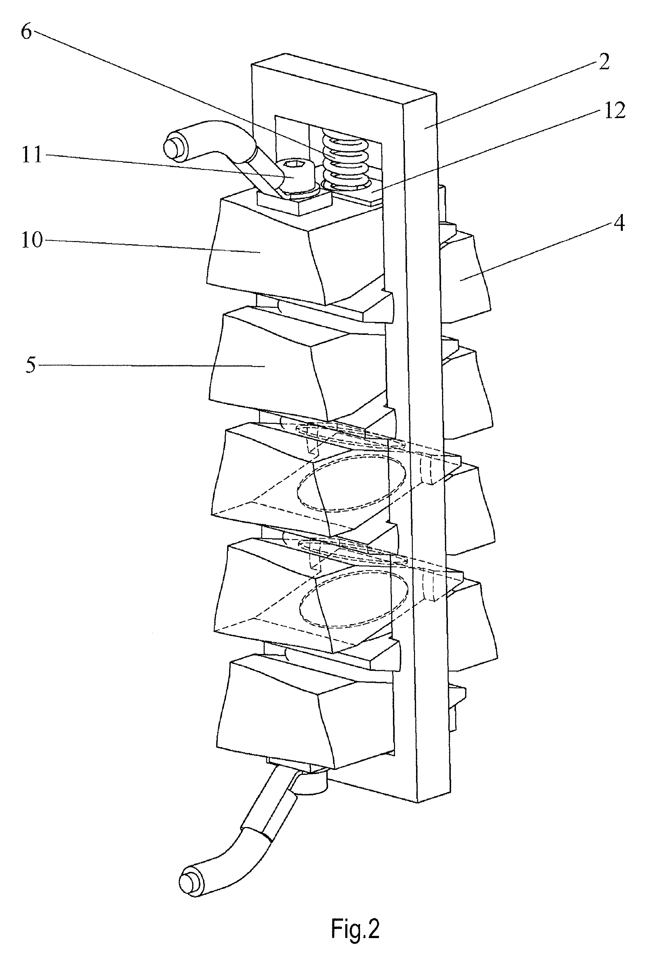

To fabricate a thermoelectric cluster, active elements (AE) 1, which may be formed in the shape of a washer, are assembled in pairs of n- and p-types of conductivity. Such sets are called as "pairs". The AEs 1 alternating n- and p-type of conductivity are resiliently urged along guides 2 of a holding frame 3 between thermoelectric conductors (TEC) 4, 5 by an elastic element 6 (Figs. 1, 2). The TECs 4, 5 are fixed from moving in other directions by the guides 2 made of an electrically non-conductive material or electrically isolated from the thermoelectric conductors 4, 5 by insulators 7. TECs 4, 5 are also alternating in such manner that some 4 receiving and transferring heat to the AE 1, while other some 5 receiving heat from the AE 1 and transferring it further. TECs 4, 5 engage directly with electrically non-conductive heat-transfer agents. The infrared (heat) radiation, electrically non-conductive liquids and vapor-gas mediums may be used as the heat-transfer agents. Thermoelectric sliding contact 8 between AE 1 and TECs 4, 5 is realized by an electrically and heat conductive non-solidifying plastic mix, or a solder having a melting point below working temperature, or a foil of a ductile metal alloy. The task of positioning AE 1 and protecting them against the environment are implemented through a positioning protective elastic member 9. The cluster may comprise any number of pairs AE 1 with n- and p-type conductivity. Therefore, the cluster is a set of pairs of AE 1 and TECs 4, 5, resiliently urged along the guides 2.

The outer TECs 10 in the cluster have a structure slightly differing them from the others. They have three distinctions. First, they have a single contact surface. Second, they are provided by an element 11 for electrical connection to the circuit of a high current. Third, they have a stop insulator 12.

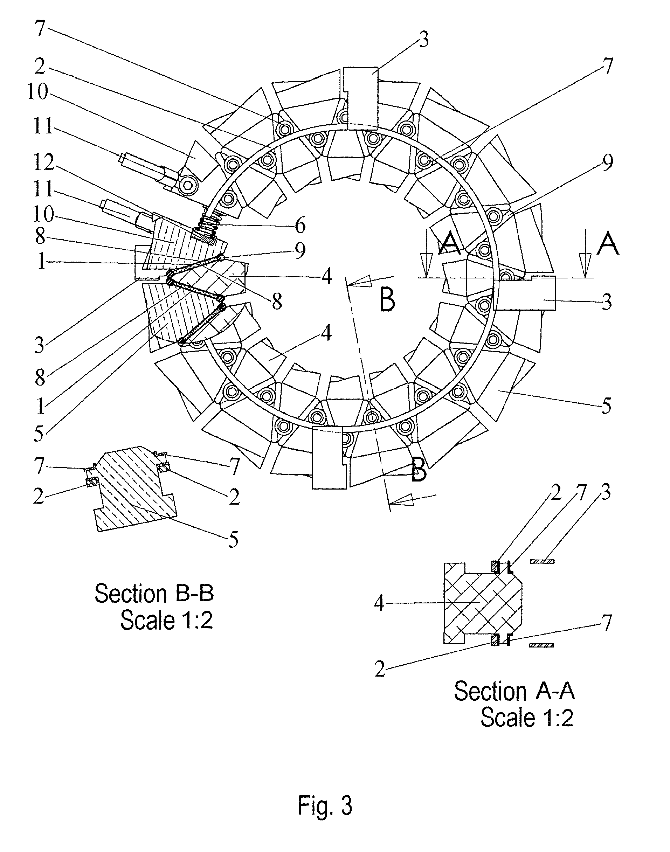

While designing particular devices the maximum number of pairs of AE 1 in the cluster can be limited only by common sense. The shape of the guides 2 of the holding frame 3 is defined in accordance with the reasonability while designing, i.e. may be straight, curved up to a closed ring (as illustrated in Figure 3) or spiral.

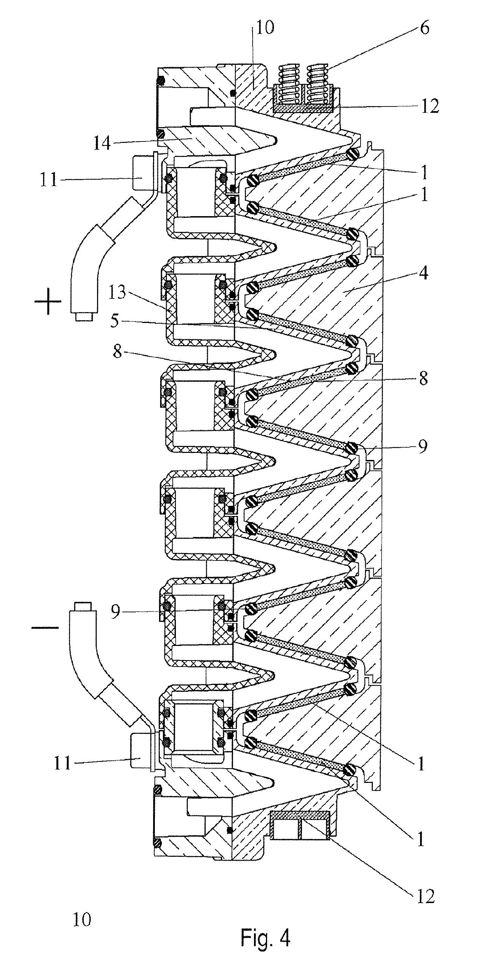

The structure of a generator according to a first embodiment is based on the above embodiment of the thermoelectric cluster consisting of six pairs of AE 1 (Figure 4).

Receiving TECs 4 are solid and made of bronze by a method of casting with moldable models followed by mechanical treatment of the contact surfaces. All receiving TECs 4 have a blackened surface to absorb infrared radiation. The receiving TECs 4 are designed so that, first, to prevent electrical contact between adjacent TECs 4 and, second, to completely cover the IR receiving areas (Figure 4).

All releasing TECs 5 are also made of bronze by a method of casting with moldable models followed by mechanical treatment of the contact surfaces. They are hollow to circulate an electrically non-conductive cooling therein. To form a channel for liquid flow each releasing TEC 5 is supplemented with a collector segment 13 made of an electrically non-conductive material. Collector segments 13 are movably interconnected in a common unit for the entire cluster. Periphery collector segments 14 are electrically conductive and have an element 11 for electrical connecting to the circuit of a high current.

Active elements 1 are formed in the shape of washers having a diameter of 23 mm and a thickness of 1.55 mm; they are manufactured of bismuth telluride obtained by powder metallurgy technique and have a two-layer coating on contact surfaces, wherein the coating includes a 20 µm thick layer of nickel and a 5 µm thick layer of gold.

To obtain the sliding contact 8 between the AE 1 and TECs 4, 5 an alloy Rose is used having the melting point of 90 degrees Celsius.

The positioning protective element 9 is being in the form of a silicone ring having an inner diameter of 22 mm in a free state, with circular section having a diameter of 3.2 mm, and placed in depressions in TECs 4, 5. Such solution provides both fixation and reliable protection of the active elements 1 from the effect of environment.

Resilient urging of TECs 4, 5 against AE 1 is implemented by an elastic element 6 consisting of six springs with the total clamping force of 120 kgf. Outer TECs 10 in the cluster are structurally slightly different from the others. The distinction is caused by two reasons. First, they have a single contact surface. Second, they comprise a stop insulator 12.

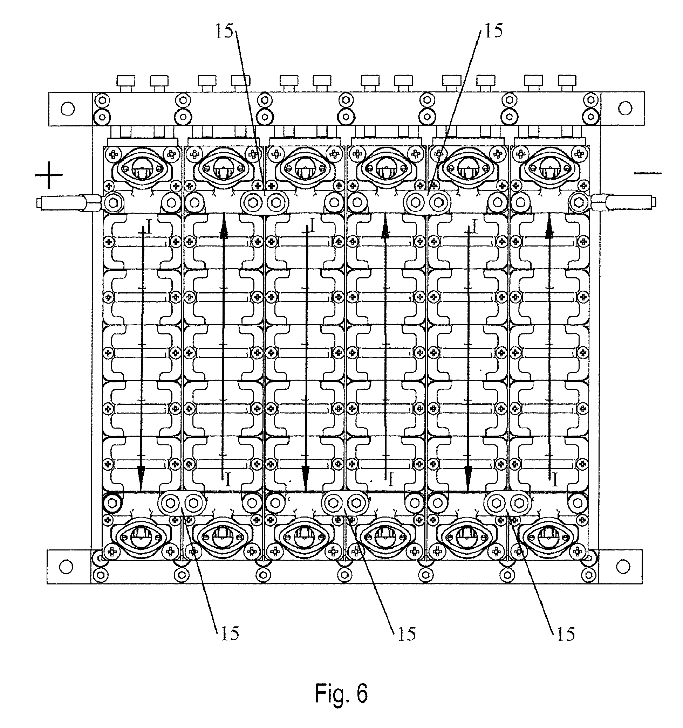

When assembled, the clusters are connected in a successive circuit by electrically conductive bridges 15 and are orientated so that the directions of electric current in adjacent clusters are mutually opposite (Figure 6).

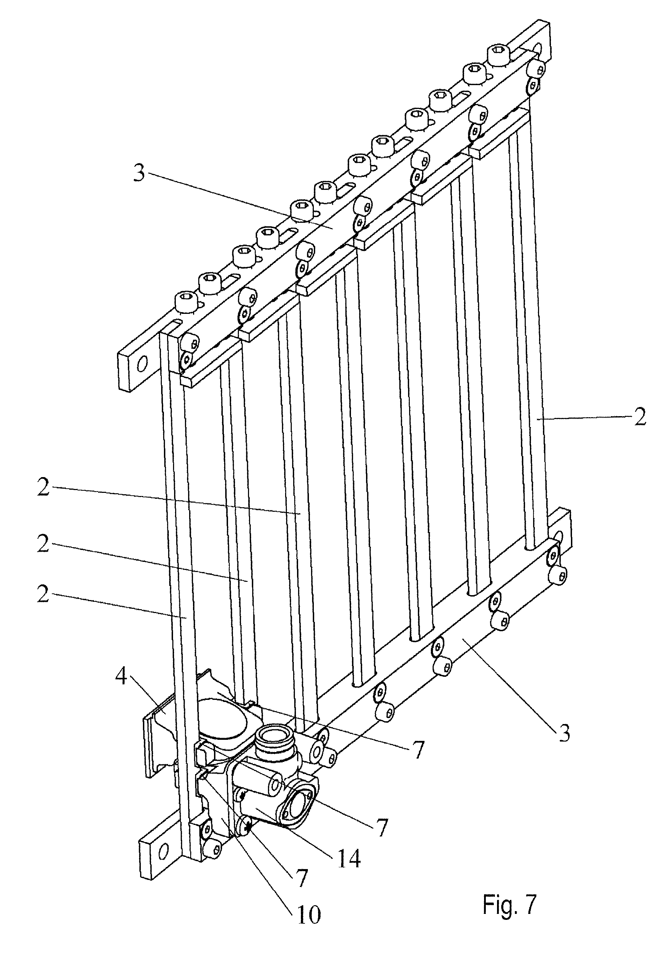

The guides 2 of all the clusters are straight, made of stainless steel and united in a common holding frame 3. Each TEC 4, 5 is isolated from the guides 2 by a ceramic insulator 7 (Figure 7).

The IR source is an infrared burner which provides orange glow of a radiating ceramic surface at a radiation temperature of 900-950 degrees Celsius, having 3 kW power and the size of the flat radiating surface of 220x140 mm, working on commercial low pressure propane/butane mixture.

The temperature of the receiving TECs 4 reaches 300 degrees Celsius. The temperature of the releasing TECs 5 reaches 80 degrees Celsius.

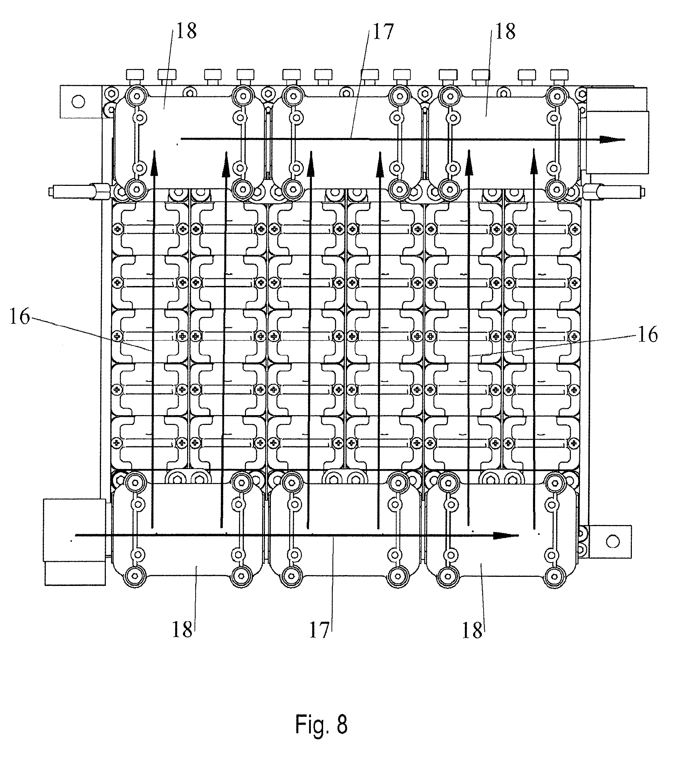

As illustrated in Figure 8, arrows 16 show flows of cooling electrically non-conductive liquid in the clusters. Arrows 17 show flows of cooling electrically non-conductive liquid in the groups of uniting collectors 18 movably connected between each other in the groups by three.

Cooling of the electrically non-conductive liquid heated by the releasing TECs 5 is realized by releasing heat into the atmosphere through two radiators with forced blow by two fans. The circulation of liquid is realized by an electric pump.

Additionally, the apparatus comprises a case, an expansion tank, a plug load, an ammeter, a voltmeter, a heat indicator and an overload indicator.

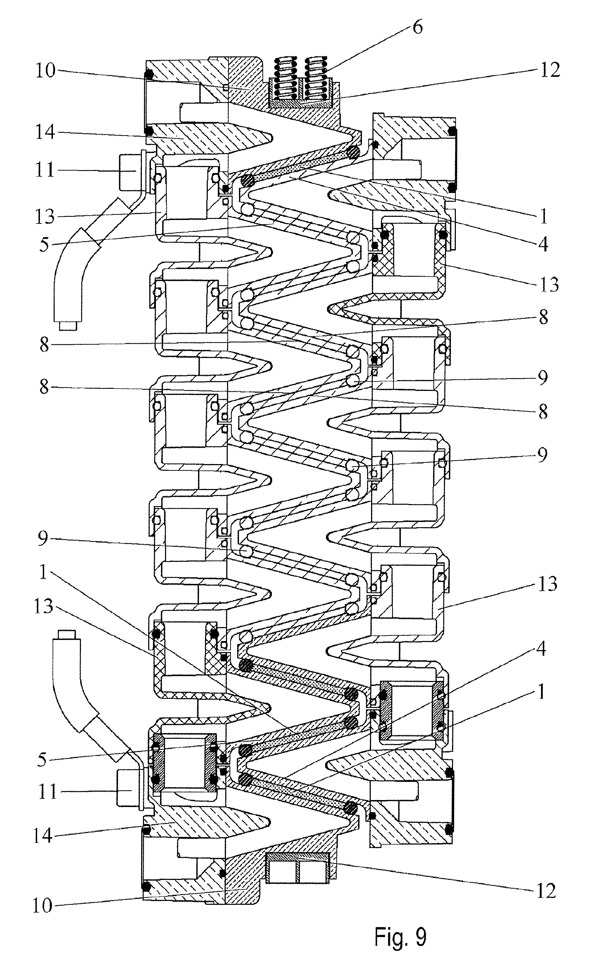

The structure of a generator according to a second embodiment is based on the above embodiment of the thermoelectric cluster consisting of six pairs of active elements 1 (Figure 9).

Receiving TECs 4 are made of bronze by a method of casting with moldable models followed by mechanical treatment of the contact surfaces. All receiving TECs 4 are hollow for circulation of heating electrically non-conductive liquid therein. To form a channel for liquid flow, every receiving TEC is supplemented with a collector segment 13 made of an electrically non-conductive material, which maintains the structural strength at the operating temperature of the heating liquid, for example of ceramics. The collector segments 13 are movably interconnected in an unit which is common for the entire cluster.

Similarly, all releasing TECs 5 are made of bronze by a method of casting with moldable models followed by mechanical treatment of the contact surfaces. They are hollow for the circulation of cooling electrically non-conductive liquid therein. To form a channel for liquid flow, every releasing TEC 5 is supplemented with a collector segment 13 made of an electrically non-conductive material. The collector segments 13 are movably interconnected in an unit which is common for the entire cluster. Periphery collector segments 14 conduct are electricity conductive and provided by an element 11 to electrical connect to the circuit of a high current.

Active elements 1 are formed in the shape of washers having a diameter of 23 mm and a thickness of 1.55 mm, they are made of bismuth telluride obtained by powder metallurgy technique, and have a two-layer coating on contact surfaces, wherein the coating includes a 20 µm thick layer of nickel and a 5 µm thick layer of gold.

To obtain the sliding contact 8 between the AE 1 and TECs 4, 5 an alloy Rose is used having the melting point of 90 degrees Celsius. The sliding contact 8 between AE 1 and releasing TECs 5 is formed using a quick gallium-based solder having the melting point of 36 degrees Celsius.

The positioning protective element 9 is in the form of a silicone ring having an inner diameter of 22 mm in a free state, with circular section having a diameter of 3.2 mm, and placed in depressions in TECs 4, 5. This solution provides both fixation and reliable protection of active elements 1 from effect of the environment.

Resilient urging of TECs 4, 5 to AE 1 is provided through an elastic element 6 consisting of six springs with a total clamping force of 120 kgf. Outer TECs 10 in the cluster are structurally slightly different from the others. The distinction is caused by two reasons. First, they have a single contact surface. Second, they comprise a stop insulator 12.

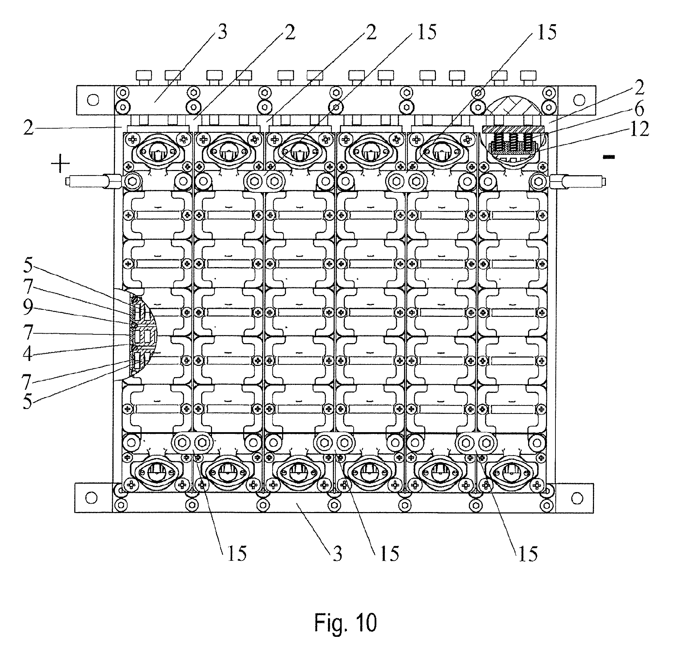

The apparatus is in the form of six identical clusters arranged adjacent to each other so that the hot side of all the clusters is orientated in one side, and the cold side is orientated in the opposite side (Figure 10).

When assembled, the clusters are connected in a series electric circuit by conductive bridges 15 and orientated so that the directions of electric current in the adjacent clusters are mutually opposite.

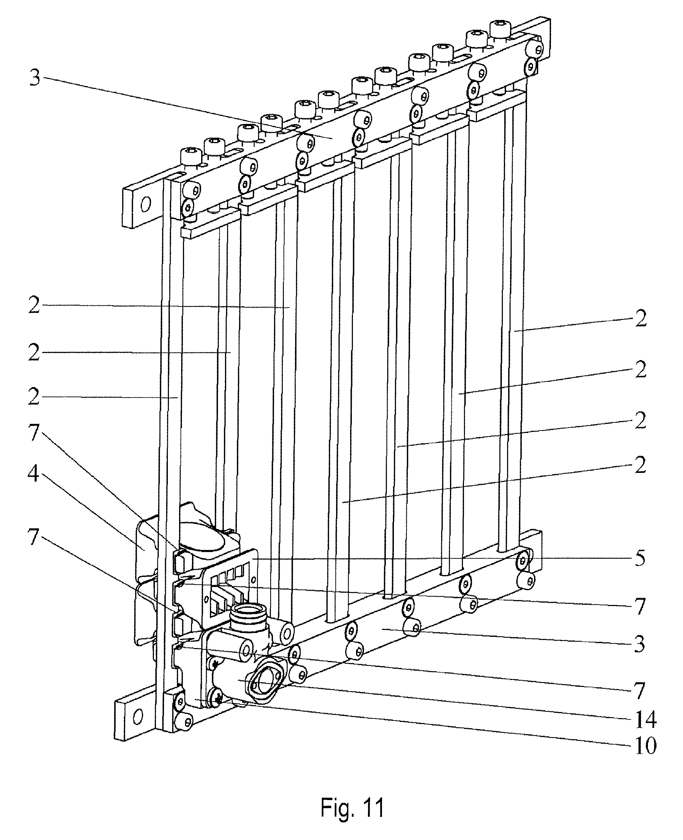

The guides 2 of all the clusters are straight, made of stainless steel and united in the common holding frame 3. Each TEC 4, 5 is isolated from the guides 2 by a ceramic insulator 7 (Figure 11).

The heating electrically non-conductive liquid receives heat in a heat exchanger from any heat source, for example, a wood-burning oven, exhaust system of internal combustion engine, power turbines, geothermal, solar sources, etc.

The temperature of receiving TECs 4 reaches 300 degrees Celsius. The temperature of releasing TECs 5 reaches 80 degrees Celsius.

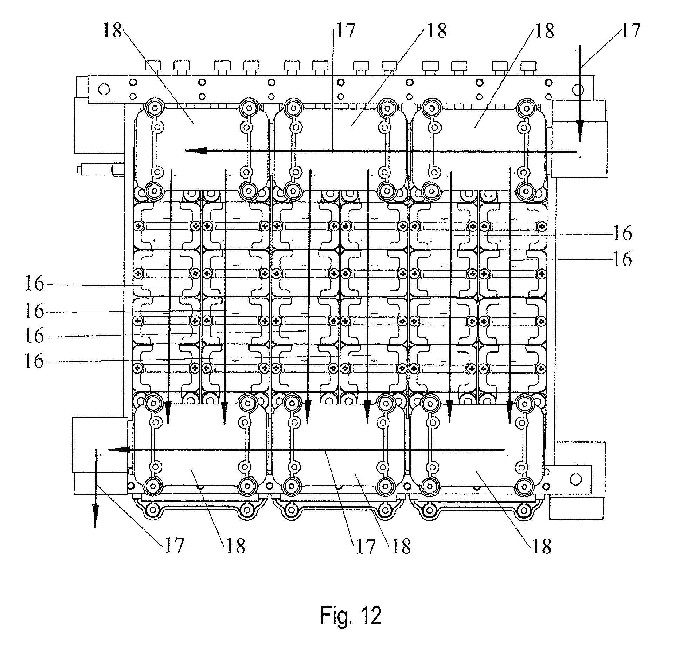

As illustrated in Figure 12, arrows 16 show flows of heating electrically non-conductive liquid in the clusters. Arrows 17 show flows of heating electrically non-conductive liquid in the groups of uniting collectors 18 movably connected between each other in the groups by three.

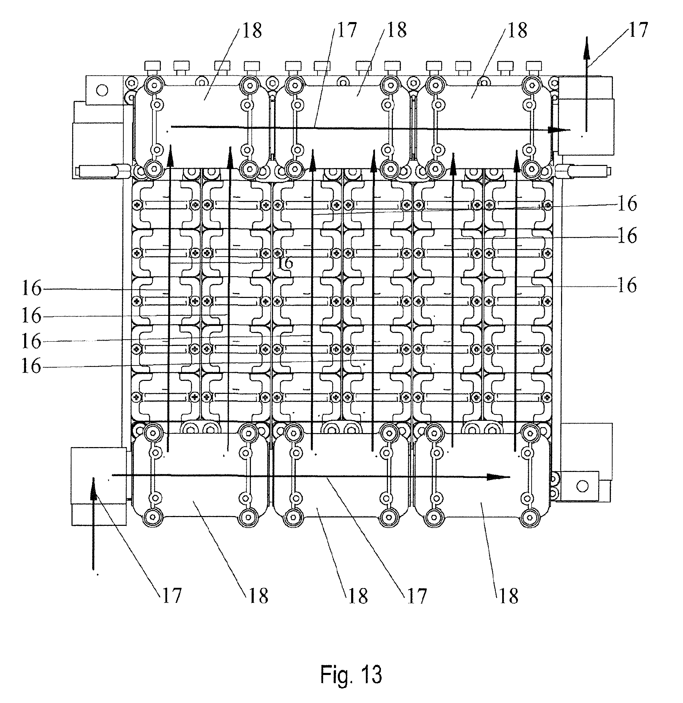

As illustrated in Figure 13, arrows 16 show flows of cooling electrically non-conductive liquid in the clusters. Arrows 17 show flows of cooling electrically non-conductive liquid in the groups of uniting collectors 18 movably connected between each other in the groups by three.

Cooling of the electrically non-conductive liquid heated by the releasing TECs 5 is realized by releasing heat into the atmosphere through two radiators with forced blow by two fans. The circulation of cooling liquid and heating liquid is executed by electric pumps.

Additionally, the apparatus comprises a case, expansion tanks, a plug load, an ammeter, a voltmeter, a heat indicator and an overload indicator.

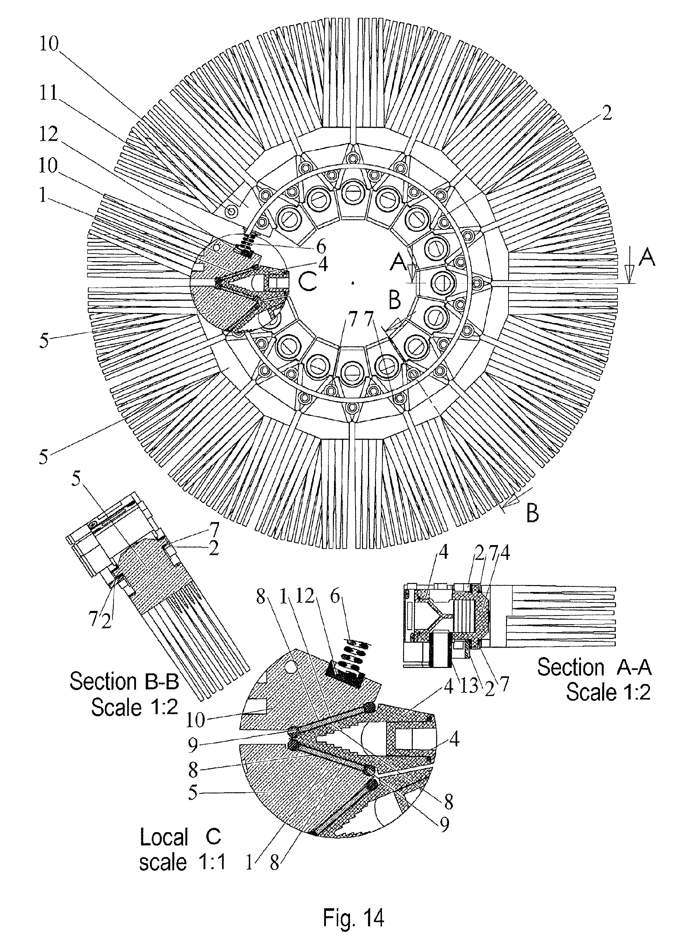

The structure of a generator according to a third embodiment is based on the above-described embodiment of the thermoelectric cluster consisting of fifteen pairs of active elements 1 and mounted on two guides 2 having a form of a round closed ring (Figure 14).

Receiving TECs 4 are made of bronze by a method of casting with moldable models followed by mechanical treatment of the contact surfaces. All receiving TECs 4 are hollow to allow the circulation of heating electrically non-conductive liquid therein. To form a channel for liquid flow each receiving TEC 4 is supplemented by a collector segment 13 made of electrically non-conductive material, which maintains the structural strength at the operating temperature of the heating liquid, for example of ceramics.

All releasing TECs 5 are also made of bronze by a method of casting with moldable models followed by mechanical treatment of the contact surfaces. Furthermore, they have an extended surface for heat exchange with vapor-gaseous medium. Periphery releasing TECs 10 is provided by a element 11 to electrical connect to the circuit of a high current, and a stop insulator 12.

Resilient urging of TECs 4, 5 to AEs 1 is implemented through an elastic element 6 consisting of a single spring with a clamping force of 100 kgf (Figure 14).

Each of the TECs 4, 5 is isolated from the guides 2 by a ceramic insulator 7.

Active elements 1 are formed in the shape of washers having a diameter of 23 mm and a thickness of 1,55 mm, they are made of bismuth telluride obtained by powder metallurgy technique, and have a two-layer coating on contact surfaces, wherein the coating includes a 20 µm thick layer of nickel and a 5 µm thick layer of gold o.

To obtain the sliding contact 8 between the AE 1 and TECs 4, 5, "Russian alloy" is used having the melting point of 3 degrees Celsius.

The positioning protective element 9 is in the form of a silicone ring having an inner diameter of 22 mm in a free state, with a circular section having a diameter of 3.2, mm and placed in depressions in TECs 4, 5. This design provides both fixation and reliable protection of active elements 1 from the effect of environment.

The apparatus is in the form of six identical clusters arranged above each other along a common axis. Guides2 of all the clusters are made of stainless steel and fixed by a common holding frame 3.

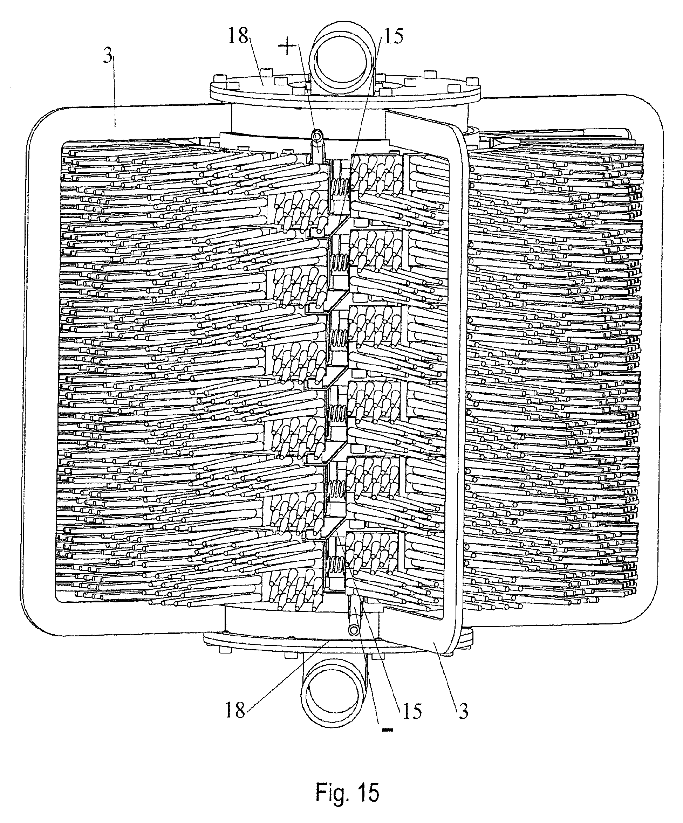

When assembled, the clusters are connected in a series electric circuit by conductive bridges 15 (Figure 15).

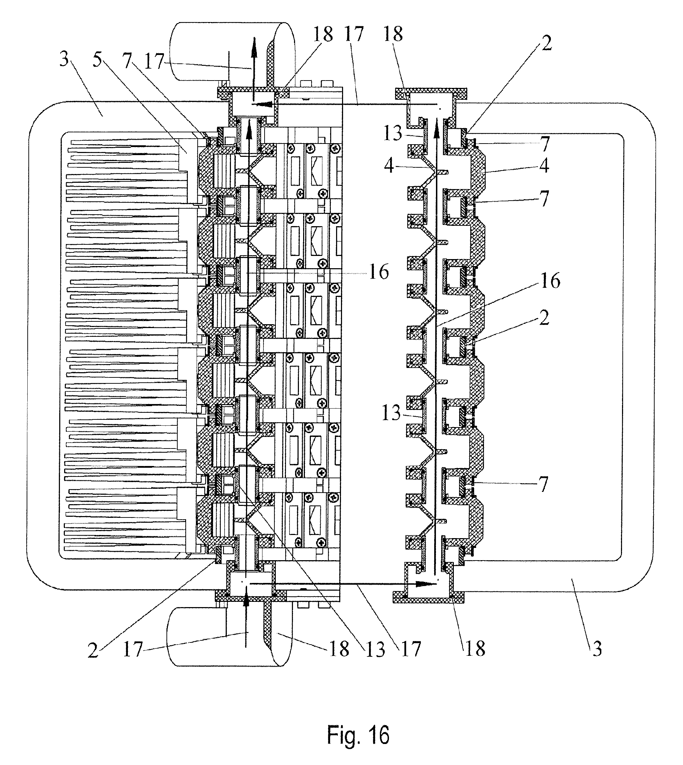

Guides2 of adjacent clusters are connected in a single common part (Figure 16).

As illustrated in Figure 16, arrows 16 show flows of an electrically non-conductive liquid in the clusters. Arrows 17 show flows of electrically non-conductive liquid in the groups of uniting collectors 18.

The apparatus is designed so that the direction of thermal stream can be changed to be reversed without losing the functionality of the device, i.e. the receiving and releasing TECs 4, 5 can swap roles. In this case, the polarity of the generated voltage will reverse.

Additionally, the apparatus comprises a case, an expansion tank, a plug load, an ammeter, a voltmeter, a heat indicator and an overload indicator.

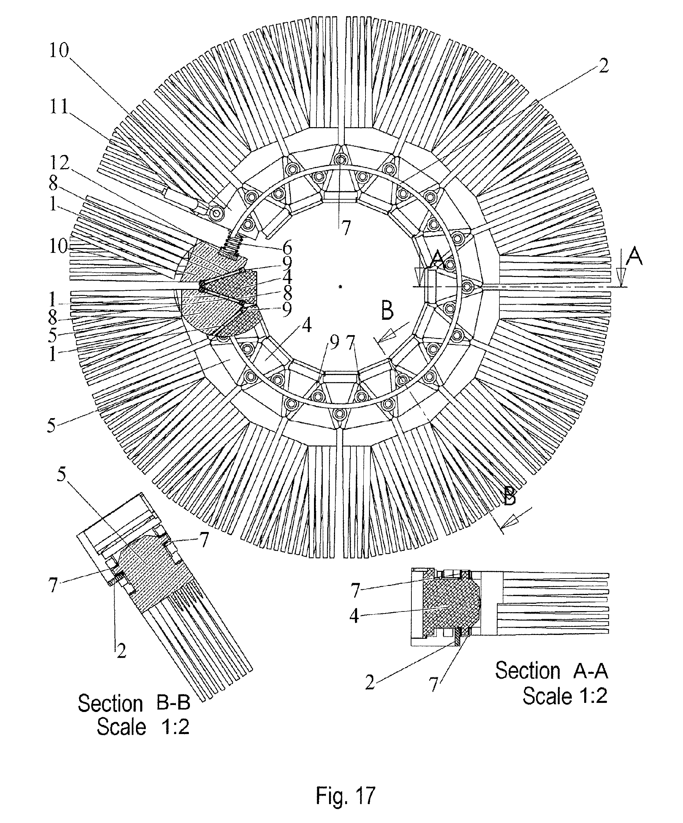

The structure of a generator according to a fourth embodiment is based on the above embodiment of the thermoelectric cluster consisting of fifteen pairs of active elements 1 and mounted on two guides2 having a form of a circular closed ring (Figure 17).

Receiving TECs 4 are made solid and in the form of bronze by a method of casting with moldable models followed by mechanical treatment of the contact surfaces. All receiving TECs 4 have blackened surfaces to absorb infrared radiation. The receiving TECs 4 are designed so that, first, to prevent electrical contact between neighboring TECs 4 and, second, to completely cover the IR receiving areas.

Similarly, all the releasing TECs 5 are made of bronze by a method of casting with moldable models followed by mechanical treatment of the contact surfaces. Furthermore, they have an extended surface for heat exchange with vapor-gaseous medium (atmospheric air). Outer releasing TECs 10 are provided by a element 11 to electrical connect to the circuit of a high current and provided by a stop insulator 12.

Resilient urging of TECs 4, 5 to AEs 1 is implemented by an elastic element 6 consisting of (here) a single spring with a clamping force of 100 kgf.

Each of the TECs 4, 5 is isolated from the guides2 by a ceramic insulator 7.

Active elements 1 are formed in the shape of washers having a diameter of 23 mm and a thickness of 1.55 mm, they are made of bismuth telluride obtained by powder metallurgy technique and have a two-layer coating on contact surfaces, wherein the coating includes a 20 µm thick layer of nickel and a 5 µm thick layer of gold.

To obtain the sliding contact 8 between the AE 1 and TECs 4, 5, an alloy Rose is used having the melting point of 90 degrees Celsius.

The positioning protective element 9 is in the form of of a silicone ring having an inner diameter of 22 mm in a free state, with circular section having a diameter of 3.2 mm, and placed in depressions in TECs 4, 5. This solution provides both fixation and reliable protection of active elements 1 from the environment.

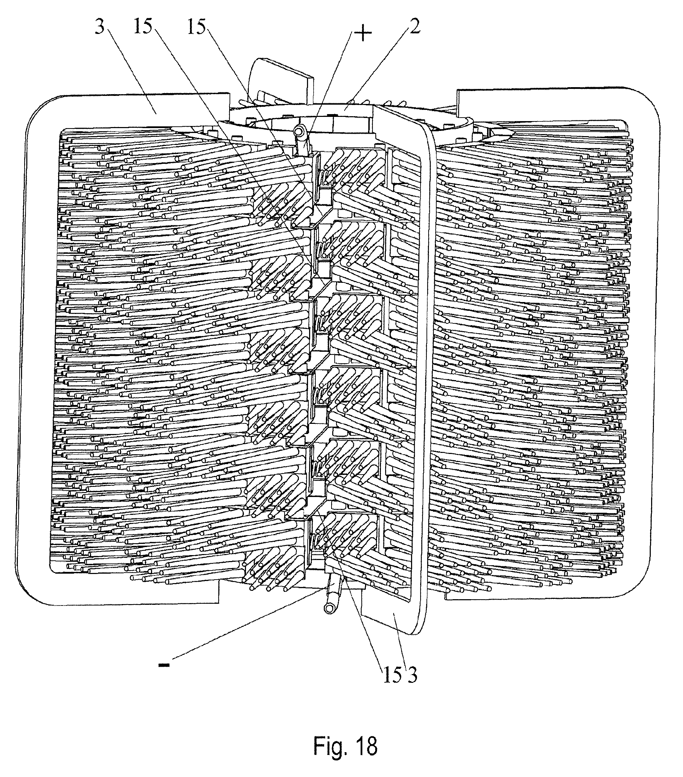

The apparatus is in the form of six identical clusters disposed on each other and forming a single cylindrical receiving surface for receiving IR radiation inside therein (Figure 18).

When assembled, the clusters are connected in a successive circuit by electrically conductive bridges 15. Guides 2 of adjacent clusters are united in a single common part.

Guides 2 of all the clusters are made of stainless steel and united by a common holding frame 3.

The IR source is an infrared miniature burner which provides orange glow of the radiating surface in the form of a conical cylinder at a radiation temperature of 900-950 degrees Celsius, having 5 kW power, the height of the radiating surface of 300 mm, working on commercial low pressure propane/butane mixture. Axis of the burner coincides with the axis of all the clusters.

The temperature of receiving TECs 4 reaches 300 degrees Celsius. The temperature of releasing TECs 5 reaches 100 degrees Celsius.

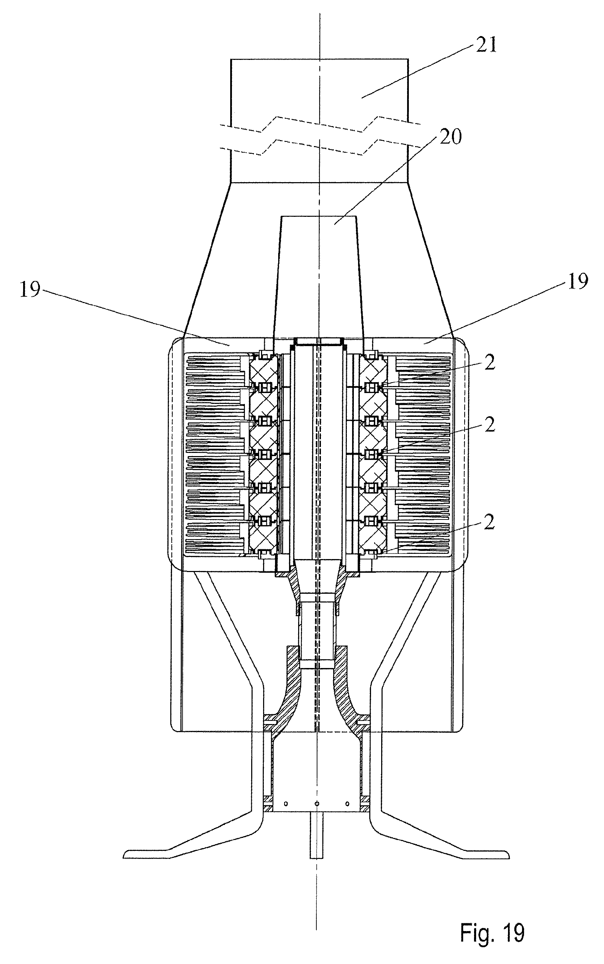

The apparatus is mounted in a case limiting between the apparatus and releasing TECs 5 an annular channel 19 which communicates in the upper portion with a channel 20 for discharging combustion products from the IR burner. Air in the channel 19 is drawn into the chimney effect of the channel 20. The heated releasing TECs 5 are cooled by releasing heat into the atmosphere through the extended ribbed surface with forced blow caused by the draft of a chimney 21 (Figure 19).

Guides2 of adjacent clusters are united in a single common unit.

Additionally, the apparatus comprises a plug load, an ammeter, a voltmeter, a heat indicator and overload indicator.

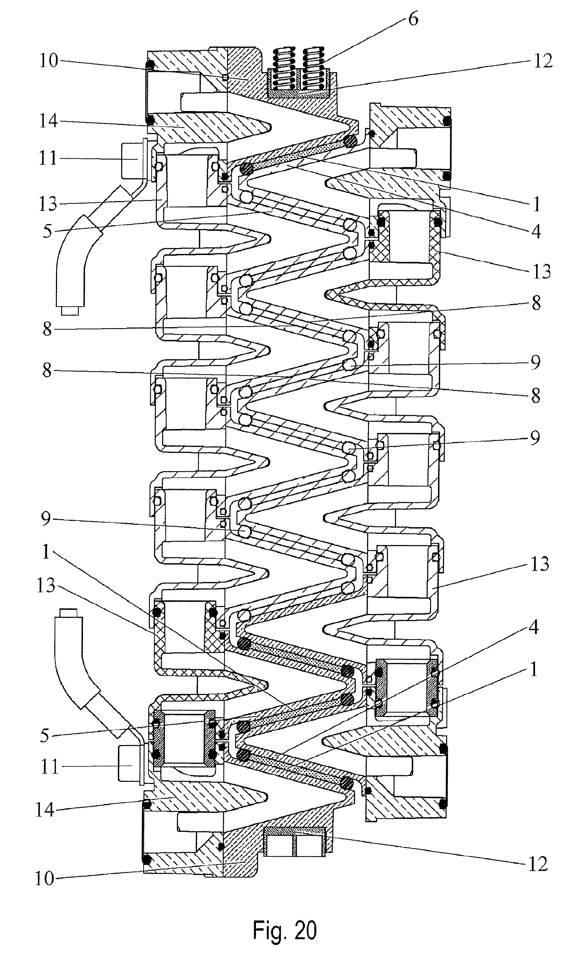

The structure of a heat pump according to a first embodiment is based on the above embodiment of the thermoelectric cluster consisting of six pairs of active elements 1 (Figure 20).

Receiving TECs 4 are made of bronze by a method of casting with moldable models followed by mechanical treatment of the contact surfaces. All receiving TECs 4 are hollow to allow circulation of cooling electrically non-conductive liquid therein. To form a channel for liquid flow, each receiving TEC 4 is supplemented by a collector segment 13 made of electrically non-conductive material. Collector segments 13 are movably connected with one another in a unit which is common for the entire cluster.

Similarly, all releasing TECs 5 are made of bronze by a method of casting with moldable models followed by mechanical treatment of the contact surfaces. Furthermore, they are hollow to allow circulation of heated electrically non-conductive liquid therein. To form a channel for liquid flow each releasing TEC 5 is supplemented by a collector segment 13 made of electrically non-conductive material. Collector segments 13 are movably connected with one another in a unit which is common for the entire cluster. Periphery collector segments 14 are electrically conductive and provided by an element 11 to electrical connect to the circuit of a high current.

Outer TECs 10 in the cluster are structurally slightly different from the others. The distinctions caused by two reasons. First, they have a single contact surface. Second, they comprise a stop insulator 12.

If the polarity of feeding voltage reverses, the receiving TECs 4 and releasing TECs 5 swap roles. That is, the direction of heat transfer reverses.

Active elements 1 are formed in the shape of washers having a diameter of 23 mm and a thickness of 1.55 mm, they are made of bismuth telluride obtained by powder metallurgy technique, and have a two-layer coating on contact surfaces, wherein the coating includes a 20 µm thick layer of nickel and a 5 µm thick layer of gold.

To obtain the sliding contact 8 between the AE 1 and TECs 4, 5, conductive paste UVS "SUPERCONT" is used, which is produced by OOO "Bers", Yekaterinburg (http://www.smazelektro.ru/ supercont.html).

The positioning protective element 9 is in the form of of a silicone ring having an inner diameter of 22 mm in a free state, with circular section having a diameter of 3.2 mm, and placed in depressions in TECs 4, 5. This design provides both fixation and reliable protection of active elements 1 from the environment.

Resilient urging of TECs 4, 5 to AEs 1 is realized by an elastic element 6 consisting of six springs with the total clamping force of 120 kgf.

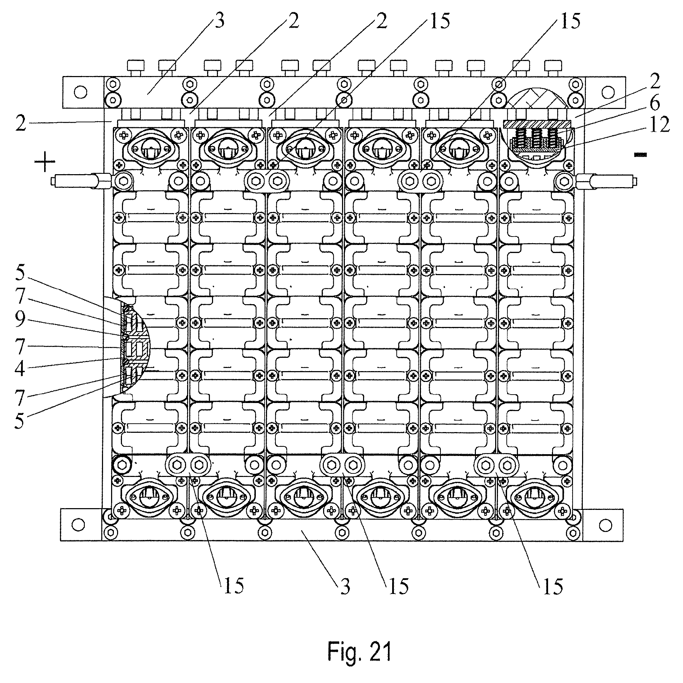

The apparatus is in the form of six identical clusters arranged adjacent to each other so that the hot side of the clusters is oriented in one side, and the cold side is oriented in the opposite side (Figure 21).

When assembled, the clusters are connected in a successive circuit by electrically conductive bridges 15 and oriented so that the directions of electric current in the adjacent clusters are mutual opposite.

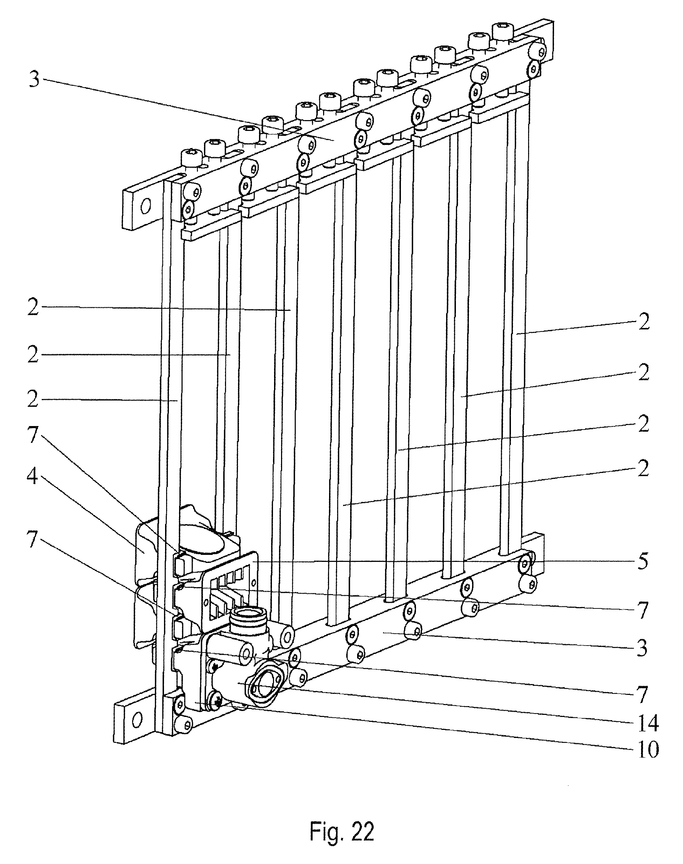

The guides2 of all the clusters are straight, made of stainless steel and united in a common holding frame 3. Each TEC 4, 5 is isolated from the guides2 by a ceramic insulator 7 (Figure 22).

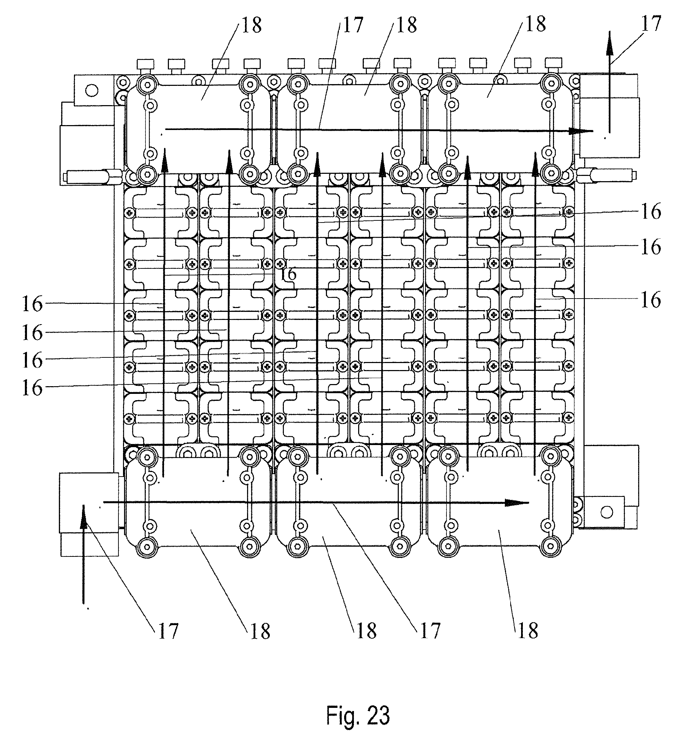

As illustrated in Figure 23, arrows 16 show flows of heated electrically non-conductive liquid in the clusters. Arrows 17 show flows of heating electrically non-conductive liquid in the groups of uniting collectors 18 movably connected between each other in the groups by three.

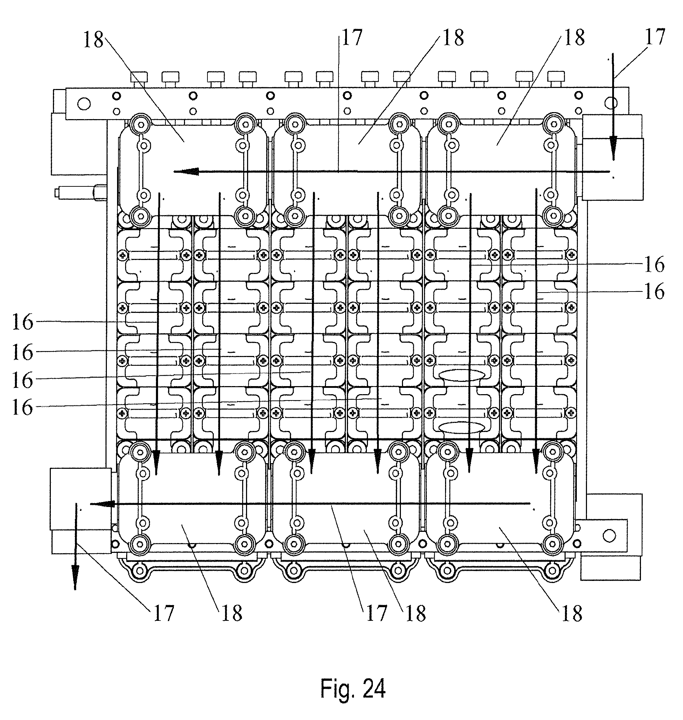

As illustrated in Figure 24, arrows 16 show flows of cooling electrically non-conductive liquid in the clusters. Arrows 17 show flows of cooling electrically non-conductive liquid in the groups of uniting collectors 18 movably connected between each other in the groups by three.

Cooling of the heated electrically non-conductive liquid is realized by releasing heat into the atmosphere through two radiators with forced blow by two fans. Heating of the cooled electrically non-conductive liquid is realized by taking away the heat from the coolable closed space through a heat exchanger. Thus, there is a targeted cooling of a closed space. If necessary, the polarity of the electrical terminals can be reversed in order to heat this closed space.

The circulation of both liquids is executed by electric pumps.

Additionally, the apparatus comprises a case, expansion tanks, a system for monitoring and adjusting the performance and direction of operation of the heat pump. The apparatus is a thermal stabilization device of a closed heat insulated volume in the conditions of variable heat release from the equipment mounted inside the closed volume and variable temperature conditions outside.

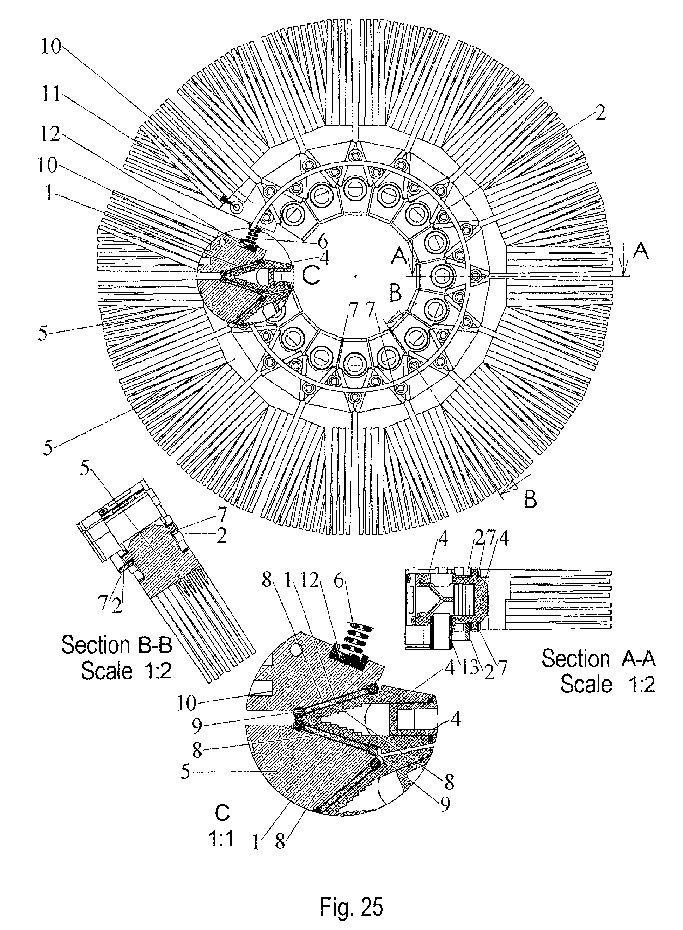

The structure of a heat pump according to a second embodiment is based on the above embodiment of the thermoelectric cluster consisting of fifteen pairs of active elements 1 and mounted on two guides2 having a shape of a circular ring (Figure 25).

Receiving TECs 4 are made of bronze by a method of casting with moldable models followed by mechanical treatment of the contact surfaces. All receiving TECs 4 are hollow to allow circulation of electrically non-conductive cooling liquid therein. To form a channel for liquid flow, each receiving TEC 4 is supplemented by a collector segment 13 made of an electrically non-conductive material.

Similarly, all releasing TECs 5 are made of bronze by a method of casting with moldable models followed by mechanical treatment of the contact surfaces. Furthermore, they have an extended surface for heat exchange with vapor-gaseous medium. Outer releasing TECs 10 have an element 11 to electrical connect to the circuit of a high current and provided by a stop insulator 12.

Resilient urging of TECs 4, 5 to AEs 1 is realized by an elastic element 6 consisting of a single spring with the clamping force of 100 kgf.

If the polarity of feeding voltage reverses, the receiving TECs 4 and releasing TECs 5 swap roles. That is, the direction of heat transfer reverses.

Active elements 1 are formed in the shape of washers having a diameter of 23 mm and a thickness of 1.5 mm, they are made of bismuth telluride obtained by powder metallurgy technique, and have a two-layer coating on contact surfaces, wherein the coating includes a 20 µm thick layer of nickel and a 5 µm thick layer of gold.

To obtain the sliding contact 8 between the AE1 and TECs 4, 5, a conductive paste UVS "SUPERCONT" is used, which is produced by OOO "Bers", Yekaterinburg (http://www.smazelektro.ru/ supercont.html).

The positioning protective element 9 is in the form of a silicone ring having an inner diameter of 22 mm in a free state, with circular section having a diameter of 3.2 mm, and placed in depressions in TECs 4, 5. This solution provides both fixation and reliable protection of active elements 1 from the effect of environment.

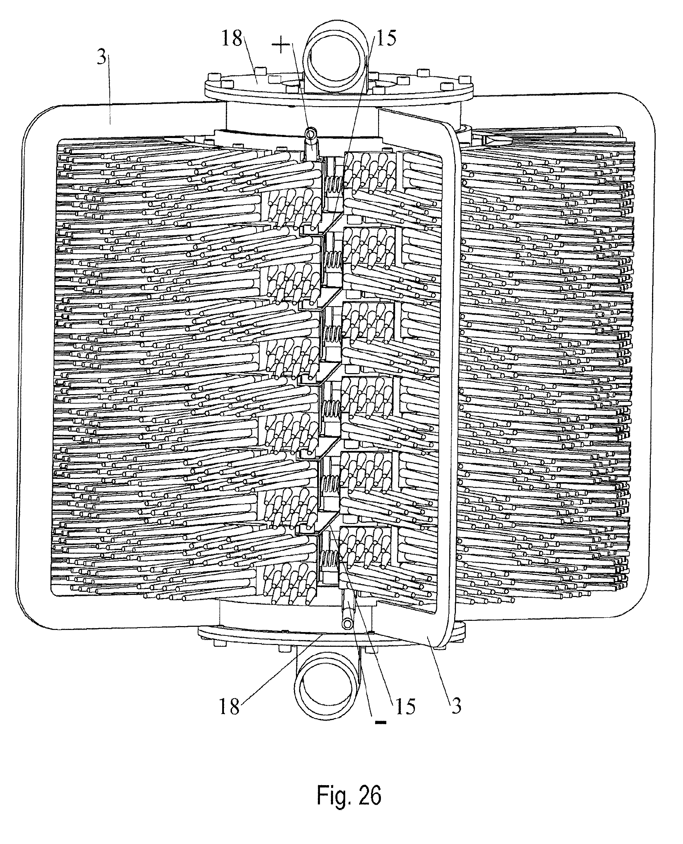

The apparatus is in the form of six identical clusters arranged above each other along a common axis. When assembled, the clusters are connected in a successive circuit by electrically conductive bridges 15 (Figure 26).

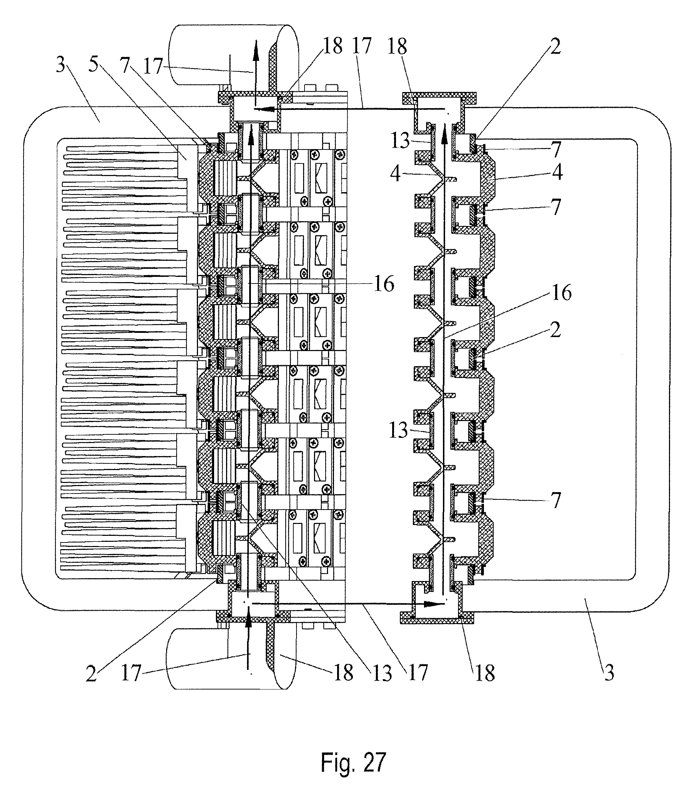

As illustrated in Figure 27, arrows 16 show flows of electrically non-conductive liquid in the clusters. Arrows 17 show flows of electrically non-conductive liquid in groups of uniting collectors 18.

Liquid is circulated by an electric pump.

Additionally, the apparatus comprises a case, an expansion tank and a system for monitoring and adjusting the performance and direction of operation of the heat pump.

## Claims

1. A method of operating a thermoelectric cluster, in which some thermoelectric conductors are engaged with a hot heat-transfer agent and other thermoelectric conductors are engaged with a cold heat-transfer agent, **characterized in that** the respective heat-transfer agent is caused to directly act on the thermoelectric conductors.

2. A device for connecting an active element to a thermoelectric conductor in a thermoelectric cluster **characterized in that** it comprises an electrically and heat conductive non-solidifying plastic mix, or a solder having a melting point below operating temperature, or a foil of a ductile metal alloy, wherein the thermoelectric conductor and the active element are resiliently urged against one another.

3. A thermoelectric cluster comprising active elements, **characterized in that** the active elements have the size in the direction of electric current no less than three times smaller than the size in the direction perpendicular thereto.

4. A thermoelectric cluster according to claim 3, wherein the active elements are joined to the thermoelectric conductors by an electrically and heat conductive non-solidifying plastic mix, or a solder having a melting point below operating temperature, or a foil of a ductile metal alloy, and are surrounded by elastic positioning protective elements placed in depressions of the thermoelectric conductors.

5. A thermoelectric cluster according to claim 3 or 4, wherein the thermoelectric conductors are in the form of wedges, resiliently urged along a row against the active elements located between them, and fixed from moving in other directions by a holding frame made of an electrically non-conductive material or electrically isolated from the thermoelectric conductors.

6. A thermoelectric cluster according to claim 5, wherein the active elements are in the form of the shape of washers.

7. A thermoelectric generator comprising at least one thermoelectric cluster having thermoelectric conductors with an infrared radiation (IR) receiving surface and liquid-cooled thermoelectric conductors, **characterized in that** the thermoelectric conductors are arranged at least in one row and are formed in the shape of wedges, and active elements are located between the wedges, said active elements have the size in the direction of electric current smaller than the size in the direction perpendicular thereto, wherein the liquid-cooled wedges are hollow to circulate a cooling electrically non-conductive liquid therein.

8. A thermoelectric generator according to claim 7, wherein the active elements are joined to the thermoelectric conductors by an electrically and heat conductive non-solidifying plastic mixture, or a solder having a melting point below operating temperature, or a foil of a ductile metal alloy, and are surrounded by elastic positioning protective elements placed in depressions of the thermoelectric conductors.

9. A thermoelectric generator according to claim 8, wherein the thermoelectric conductors are resiliently urged along a row against the active elements located between them, and fixed from moving in other directions by a holding frame made of an electrically non-conductive material or electrically isolated from the thermoelectric conductors.

10. A thermoelectric generator according to claim 9, wherein said liquid-cooled wedges are joined to a collector being in the form of separate parts movably connected with one another along the row of wedges.

11. A thermoelectric generator comprising at least one thermoelectric cluster having thermoelectric conductors heated by hot liquid and thermoelectric conductors cooled by cold liquid, **characterized in that** the thermoelectric conductors are arranged at least in one row and being in the form of hollow wedges to circulate respective electrically non-conductive liquids therein, wherein active elements located between the wedges have the size in the direction of electric current smaller than the size in the direction perpendicular thereto.

12. A thermoelectric generator according to claim 11, wherein the active elements are joined to the thermoelectric conductors by an electrically and heat conductive non-solidifying plastic mix, or a solder having a melting point below operating temperature, or a foil of a ductile metal alloy, and are surrounded by elastic positioning protective elements placed in depressions of the thermoelectric conductors.

13. A thermoelectric generator according to claim 12, wherein the thermoelectric conductors arranged in a row and the active elements are resiliently urged against one another along the row and fixed from moving in other directions by a holding frame made of the electrically non-conductive material or electrically isolated from the thermoelectric conductors.

14. A thermoelectric generator according to claim 13, wherein cavities of the hot thermoelectric conductors are joined to a collector for a hot electrically non-conductive liquid, and cavities of the cold thermoelectric conductors are joined to a collector for a cold electrically non-conductive liquid, said collectors being in the form of separate parts movably connected with one another along the row of wedges.

15. A thermoelectric generator according to any one of claims 11-14, wherein the generator is mounted in a case and further comprises means for heating the hot electrically non-conductive liquid, at least one radiator to cool the cold electrically non-conductive liquid, a pump to circulate the cold electrically non-conductive liquid, a pump to circulate the hot electrically non-conductive liquid, expansion tanks, at least one fan, a plug load, an ammeter, a voltmeter, a heat indicator and an overload indicator.

16. A thermoelectric generator comprising at least one thermoelectric cluster having thermoelectric conductors heated or cooled by a liquid heat-transfer agent, and thermoelectric conductors respectively cooled or heated by a gaseous medium, **characterized in that** the thermoelectric conductors are formed in the shape of wedges, active elements are located between the wedges, the active elements have the size in the direction of electric current smaller than the size in the direction perpendicular thereto, wherein the wedges contacting with the liquid heat-transfer agent are hollow to circulate an electrically non-conductive liquid therein, and the wedges contacting with the gaseous medium have ribs to cooperate with the gaseous medium.

17. A thermoelectric generator according to claim 16, wherein the active elements are joined to the thermoelectric conductors by an electrically and heat conductive non-solidifying plastic mixture, or a solder having a melting point below operating temperature, or a foil of a ductile metal alloy, and are surrounded by elastic positioning protective elements placed in depressions of the thermoelectric conductors.

18. A thermoelectric generator according to claim 17, wherein the thermoelectric conductors are resiliently urged against the active elements and fixed from moving in other directions by a holding frame made of an electrically non-conductive material or electrically isolated from the thermoelectric conductors.

19. A thermoelectric generator according to claim 18, wherein said wedges contacting with the liquid heat-transfer agent are engaged with a collector being in the form of separate parts movably connected with one another.

20. A thermoelectric generator comprising a thermoelectric cluster having thermoelectric conductors with an infrared radiation receiving surface and thermoelectric conductors cooled by a gaseous medium, **characterized in that** said thermoelectric conductors are arranged coaxially with an infrared radiation (IR) source or formed in the shape of circumferentially arranged wedges, active elements are located between the conductors, said active elements have the size in the direction of electric current smaller than the size in the direction perpendicular thereto, wherein inner thermoelectric conductors are configured to cooperate with the IR source, and outer thermoelectric conductors have ribs to cooperate with the gaseous medium.

21. A thermoelectric generator according to claim 20, wherein the connection between the active element and the thermoelectric conductors comprises an electrically and heat conductive non-solidifying plastic mix, or a solder having a melting point below operating temperature, or a foil of a ductile metal alloy, and an elastic positioning protective elements surrounding the active element.

22. A thermoelectric generator according to claim 21, wherein the thermoelectric conductors are resiliently urged against the active elements located between them and fixed from moving in other directions by a holding frame made of an electrically non-conductive material or electrically isolated from the thermoelectric conductors.

23. A thermoelectric generator according to any one of claims 20-22, wherein the generator is mounted in a case limiting an annular channel between the generator and the outer thermoelectric conductors, said channel communicates in the upper portion with a discharge channel for discharging combustion products of the IR source.

24. A heat pump comprising at least one thermoelectric cluster having thermoelectric conductors, some of the thermoelectric conductors being connected to a circuit of one heat-transfer agent and the other thermoelectric conductors being connected to a circuit of other heat-transfer agent, **characterized in that** said thermoelectric conductors are arranged at least in one row and formed in the shape of hollow wedges to circulate respective electrically non-conductive liquids therein, wherein active elements located between the wedges have the size in the direction of electric current smaller than the size in the direction perpendicular thereto.

25. A heat pump according to claim 24, wherein the active elements are joined to the thermoelectric conductors by an electrically and heat conductive non-solidifying plastic mixture, or a solder having a melting point below operating temperature, or a foil of a ductile metal alloy, and are surrounded by elastic positioning protective elements placed in depressions of the thermoelectric conductors.

26. A heat pump according to claim 25, wherein the thermoelectric conductors arranged in the row and the active elements are resiliently urged against one another along the row and fixed from moving in other directions by a holding frame made of an electrically non-conductive material or electrically isolated from the thermoelectric conductors.

27. A heat pump according to claim 26, wherein cavities of the wedges are joined to respective collectors, one of the collectors being communicated to one circuit and the other being communicated to the other circuit, wherein the collectors are in the form of separate parts movably connected with one another along the row of wedges.

28. A heat pump comprising at least one thermoelectric cluster having thermoelectric conductors contacting with a circuit of a liquid heat-transfer agent and thermoelectric conductors contacting with a gaseous medium, **characterized in that** the thermoelectric conductors are formed in the shape of wedges, active elements are located between the conductors, said active elements have the size in the direction of electric current smaller than the size in the direction perpendicular thereto, wherein the wedges contacting with the liquid heat-transfer agent are hollow to circulate an electrically non-conductive liquid therein, and the wedges contacting with gaseous medium have ribs to cooperate with the gas medium.

29. A heat pump according to claim 28, wherein the active elements are joined to the thermoelectric conductors by an electrically and heat conductive non-solidifying plastic mixture, or a solder having a melting temperature point below operating temperature, or a foil of a ductile metal alloy, and are surrounded by elastic positioning protective elements placed in depressions of the thermoelectric conductors.

30. A heat pump according to claim 29, wherein the thermoelectric conductors are resiliently urged against the active elements and fixed from moving in other directions by a holding frame made of an electrically non-conductive material or electrically isolated from the thermoelectric conductors.

31. A heat pump according to claim 30, wherein the wedges contacting with the liquid heat-transfer agent are engaged with a collector being in the form of separate parts movably connected with one another.
